# EUROPEAN PATENT APPLICATION

(11) **EP 4 321 880 A1**
(43) Date of publication of application: **14.02.2024**
(21) Application number: 22826949.4
(22) Date of filing: 04.01.2022
(51) Int. Cl.: G01R 31/00

(54) **PERFORMANCE PARAMETER RECORDING METHOD AND APPARATUS, INVERTER, AIR CONDITIONING DEVICE, AND STORAGE MEDIUM**

(30) Priority: 21.06.2021 CN 202110688466
(71) Applicant: HEFEI MIDEA HEATING & VENTILATING EQUIPMENT CO., LTD., Boyan Science Park, High-Tech Zone, Hefei Anhui 230088 (CN); GD Midea Heating & Ventilating Equipment Co., Ltd., Foshan, Guangdong 528311 (CN)
(72) Inventor: WANG, Haohao, Hefei, Anhui 230088 (CN); HONG, Weihong, Hefei, Anhui 230088 (CN); LU, Deqiang, Hefei, Anhui 230088 (CN); CHEN, Junhua, Hefei, Anhui 230088 (CN); ZHOU, Chao, Hefei, Anhui 230088 (CN); PENG, Guobin, Hefei, Anhui 230088 (CN); ZHONG, Mingsheng, Hefei, Anhui 230088 (CN)
(74) Representative: RGTH
(86) International application number: PCT/CN2022/070152
(87) International publication number: WO 2022/267438

(57) **Abstract**

Provided are a method for performance parameter recording and apparatus, a frequency inverter, an air conditioner, and a storage medium. The method includes: obtaining first sampling data by sampling a performance parameter of the frequency inverter based on a first predetermined sampling period (S11); obtaining second sampling data by sampling a performance parameter of the frequency inverter based on a second predetermined sampling period (S12), in which the first predetermined sampling period is smaller than the second predetermined sampling period; and storing, in response to a fault in the frequency inverter, fault data prior to and subsequent to the fault in the frequency inverter, in which the fault data includes the first sampling data and the second sampling data (S13). By using the method, it is possible to analyze a cause of the fault in the frequency inverter conveniently.

## Description

The present application claims priority to Chinese Patent Application No. 202110688466.5, titled "PERFORMANCE PARAMETER RECORDING METHOD AND APPARATUS, FREQUENCY INVERTER, AIR CONDITIONER, AND STORAGE MEDIUM", filed with China National Intellectual Property Administration on June 21, 2021, the entire disclosure of which is incorporated herein by reference.

### FIELD

The present disclosure relates to the field of frequency inverter technologies, and more particularly, to a performance parameter recording method and apparatus, a frequency inverter, an air conditioner, and a storage medium.

### BACKGROUND

A variable frequency technology is a technology for converting a direct current into an alternating current with different frequencies. It is inevitable to have an occasional fault in a device using the variable frequency technology due to a long operation time and a complex operation condition.

In order to facilitate a user in subsequently identifying a fault type of the device, it is necessary to set corresponding fault codes for different types of faults in advance. However, the user can only determine what kind of fault has occurred based on the fault codes, but cannot determine a cause of the fault.

In order to determine the cause of the device, it is usually necessary to use an oscilloscope to monitor a current waveform and a bus voltage waveform of the device, and then the cause of the fault can be located in combination with specific operation condition data and engineering expertise. However, the use of the oscilloscope has limitations: 1, it is impossible that all devices may be monitored by being connected to the oscilloscope; and 2, some faults occur once for a long time, and therefore, it is impossible that all the devices is connected to the oscilloscope for a long time in order to capture a fault waveform.

### SUMMARY

One of the objects of embodiments of the present disclosure is to provide a performance parameter recording method, capable of solving a problem in the related art of inconvenient operation caused by a need to be connected to an oscilloscope during detection of a fault in a device.

In a first aspect, the embodiments of the present disclosure provide a performance parameter recording method. The performance parameter recording method is for a frequency inverter and includes: obtaining first sampling data by sampling a performance parameter of the frequency inverter based on a first predetermined sampling period; obtaining second sampling data by sampling a performance parameter of the frequency inverter based on a second predetermined sampling period, the first predetermined sampling period being smaller than the second predetermined sampling period; and storing, in response to a fault in the frequency inverter, fault data prior to and subsequent to the fault in the frequency inverter, the fault data including the first sampling data and the second sampling data.

In a second aspect, the embodiments of the present disclosure provide a performance parameter recording apparatus. The performance parameter recording apparatus is for a frequency inverter and includes: a first sampling data determination module configured to obtain first sampling data by sampling a performance parameter of the frequency inverter based on a first predetermined sampling period; a second sampling data determination module configured to obtain second sampling data by sampling a performance parameter of the frequency inverter based on a second predetermined sampling period, the first predetermined sampling period being smaller than the second predetermined sampling period; and a fault data storage module configured to store, in response to a fault in the frequency inverter, fault data prior to and subsequent to the fault in the frequency inverter, the fault data including the first sampling data and the second sampling data.

In a third aspect, the embodiments of the present disclosure provide a frequency inverter. The frequency inverter includes: a memory; a processor; and a computer program stored on the memory and executable on the processor. The processor is configured to execute the computer program to implement the method described in the first aspect.

In a fourth aspect, the embodiments of the present disclosure provide an air conditioner. The air conditioner includes the frequency inverter described in the third aspect.

In a fifth aspect, the embodiments of the present disclosure provide a storage medium. The storage medium has a computer program stored thereon. The computer program, when executed by a processor, implements the method described in the first aspect.

In a six aspect, the embodiments of the present disclosure provide a computer program product. The computer program product, when running on a terminal device, causes an air conditioner to perform the method described in the first aspect.

In the embodiments of the present disclosure, since the fault data consists of the data prior to the fault in the frequency inverter and the data subsequent to the fault in frequency inverter, an accurate analysis result can be obtained after the fault data is subsequently analyzed, i.e., the cause of the fault can be obtained. Meanwhile, since the fault data is recorded by the frequency inverter itself, and the frequency inverter does not need to be connected to the oscilloscope, operation convenience can be improved. In addition, since the fault data is obtained by sampling the performance parameters of the frequency inverter in the two different sampling periods, sampling data in different sampling periods can be obtained. As a result, subsequent analysis of the performance parameters from different angles is facilitated, i.e., accuracy of the subsequently obtained analysis result is improved.

### BRIEF DESCRIPTION OF THE DRAWINGS

In order to clearly illustrate technical solutions of embodiments of the present disclosure, drawings used in embodiments are briefly described below.
FIG. 1 is a flowchart of a first performance parameter recording method according to Embodiment 1 of the present disclosure.
FIG. 2 is a flowchart of a second performance parameter recording method according to Embodiment 2 of the present disclosure.
FIG. 3 is a flowchart of a third performance parameter recording method according to Embodiment 3 of the present disclosure.
FIG. 4 is a flowchart of another performance parameter recording method according to Embodiment 3 of the present disclosure.
FIG. 5 is a flowchart of a frequency inverter after receiving an instruction of a communication device according to Embodiment 3 of the present disclosure.
FIG. 6 is a schematic diagram of a waveform corresponding to an overcurrent fault displayed by an oscilloscope according to Embodiment 3 of the present disclosure.
FIG. 7 is a schematic diagram of a fault waveform obtained by reconstructing first sampling data according to Embodiment 3 of the present disclosure.
FIG. 8 is a schematic diagram of a fault waveform obtained by reconstructing second sampling data according to Embodiment 3 of the present disclosure.
FIG. 9 is a schematic diagram of a corresponding operation waveform during operation of a frequency inverter displayed by an oscilloscope according to Embodiment 3 of the present disclosure.
FIG. 10 is a schematic diagram of an operation waveform obtained by reconstructing first sampling data according to Embodiment 3 of the present disclosure.
FIG. 11 is a schematic structural diagram of a performance parameter recording apparatus according to Embodiment 4 of the present disclosure.
FIG. 12 is a schematic structural diagram of a frequency inverter according to Embodiment 5 of the present disclosure.

### DETAILED DESCRIPTION

In the following description, for illustration and not for limitation, specific details such as particular system structures, techniques, and so on, are provided for a thorough understanding of the embodiments of the present disclosure. However, those skilled in the art would appreciate that the present disclosure can be realized in other embodiments without these specific details. In other cases, detailed descriptions of well-known systems, devices, circuits and methods are omitted to avoid unnecessary details that would impede the description of the present disclosure.

It should be understood that a term "comprise", when used in this specification and appended claims, indicates presence of stated features, integers, steps, operations, elements and/or components, but does not preclude presence or addition of one or more other features, integers, steps, operations, elements, components, and/or groups thereof.

It should also be understood that a term "and/or" used in the description of the present disclosure and the appended claims refers to any combination of one or more of the associated listed items and the possible combinations thereof, and includes these combinations.

In addition, in the description of this specification and the appended claims, terms "first", "second", etc., are used only to distinguish the description and are not to be understood as indicating or implying relative importance.

Reference throughout this specification to "an embodiment," "some embodiments," means that a particular feature, structure, material, or characteristic described in connection with the embodiment is included in one or more embodiments or examples of the present disclosure. Thus, appearances of phrases "in an embodiment," "in some embodiments," or "in some other embodiments," in various places throughout this specification are not necessarily referring to the same embodiment of the present disclosure, but mean "one or more but not all embodiments" unless otherwise specifically emphasized in other manners.

### Embodiment 1:

In an existing method, a device (such as a frequency inverter) is mainly monitored by an oscilloscope, and a corresponding waveform for the frequency inverter is observed when a fault occurs in the frequency inverter to determine a cause of the fault in the frequency inverter. However, since the frequency inverter cannot be connected to the oscilloscope for a long time, it is difficult to conveniently and accurately determine the cause of the fault in the frequency inverter.

In order to solve the technical problem, embodiments of the present disclosure provide a performance parameter recording method.

In the embodiments of the present disclosure, the provided performance parameter recording method is applied to the frequency inverter (such as a Microcontroller Unit (MCU) of the frequency inverter). In this embodiment, performance parameters of the frequency inverter are sampled in different sampling periods, and fault data prior to and subsequent to the fault in the frequency inverter (i.e., first sampling data and second sampling data that are obtained by sampling in the different sampling periods) are stored. Since the frequency inverter itself stores the fault data, the frequency inverter does not need to be constantly connected to the oscilloscope, and a worker can analyze the fault in the frequency inverter subsequently through the fault data stored in the frequency inverter. In addition, since the performance parameters are sampled in the different sampling periods, overall and local analysis can be carried out on the performance parameters subsequently based on the obtained different sampling data. Therefore, accuracy of an analysis result is improved.

A performance parameter recording method according to the embodiments of the present disclosure is described below with reference to the accompanying drawings.

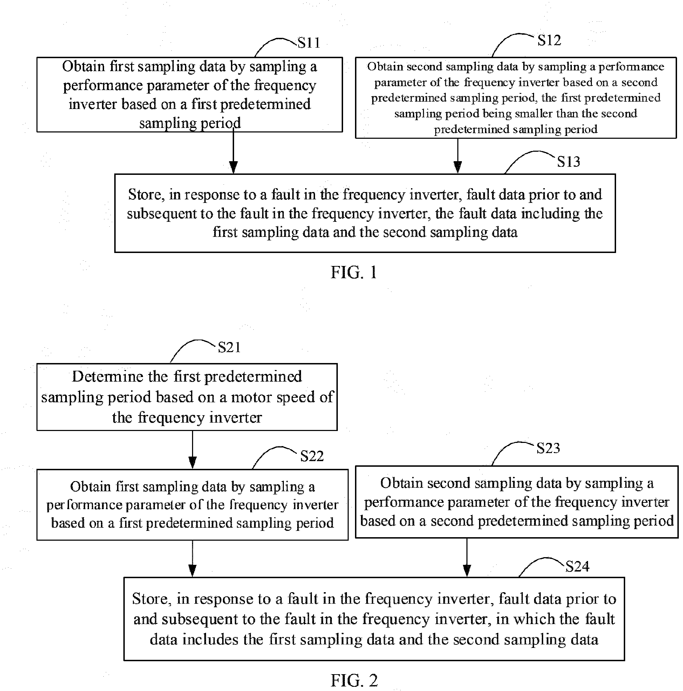

FIG. 1 illustrates a flowchart of a first performance parameter recording method according to Embodiment 1 of the present disclosure. The method is for a frequency inverter, and details thereof are described as follows.

At step S11, first sampling data is obtained by sampling a performance parameter of the frequency inverter based on a first predetermined sampling period.

The performance parameter herein refers to data capable of reflecting performance of the frequency inverter, such as a current, a voltage, a motor speed.

The first sampling period herein is a short sampling period. After the first sampling data sampled in the first sampling period is reconstructed, an obtained waveform can reflect specific information of a single waveform.

At step S12, second sampling data is obtained by sampling a performance parameter of the frequency inverter based on a second predetermined sampling period. The first predetermined sampling period is smaller than the second predetermined sampling period.

The second sampling period herein refers to a period longer than the first sampling period. After the second sampling data sampled in the second sampling period is reconstructed, an obtained waveform can reflect an overall trend.

At step S 13, in response to a fault in the frequency inverter, fault data prior to and subsequent to the fault in the frequency inverter are stored. The fault data includes the first sampling data and the second sampling data.

In this embodiment, after the performance parameter sampled in the first sampling period is restored, a local situation of the performance parameter may be reflected (there is no need to observe each waveform situation); and after the performance parameter sampled in the second sampling period is restored, an overall situation of the performance parameter may be reflected (each waveform situation can be observed). For example, this second sampling period is 20 milliseconds (ms). In some embodiments, when the first sampling data and the second sampling data are stored, the first sampling data and the second sampling data are identified, respectively, to distinguish the different sampling data. In this way, the different sampling data can be subsequently identified based on identifiers. Therefore, a waveform corresponding to the first sampling data is restored, and a waveform corresponding to the second sampling data is restored.

In the embodiments of the present disclosure, since the fault data (i.e., the first sampling data obtained by sampling in the first predetermined sampling period and the second sampling data obtained by sampling in the second predetermined sampling period) consists of the corresponding data prior to the fault in the frequency inverter and the corresponding data subsequent to the fault in the frequency inverter, the fault can be accurately analyzed subsequently based on the fault data. Meanwhile, since the fault data is recorded by the frequency inverter itself, and the frequency inverter does not need to be connected to the oscilloscope, operation convenience can be improved. In addition, since the fault data is obtained by sampling the performance parameters in the first sampling period and in the second sampling period, the sampling data in the different sampling periods can be obtained. As a result, subsequent analysis of the performance parameters from different angles is facilitated, i.e., accuracy of the subsequently obtained analysis result is improved.

### Embodiment 2:

FIG. 2 illustrates a flowchart of a second performance parameter recording method according to Embodiment 2 of the present disclosure. On the basis of Embodiment 1, this embodiment adds an action at step S21. Actions at steps S22, S23, and S24 are the same as the actions at steps S11, S12, and S13 in Embodiment, and details thereof are not repeated herein.

At step S21, the first predetermined sampling period is determined based on a motor speed of the frequency inverter.

The motor speed refers to a motor speed of the frequency inverter.

In this embodiment, the motor speed has an influence on an electrical period of the frequency inverter. Therefore, in order to obtain data of at least two (or more than 5) electrical cycle waveforms and ensure that the restored waveforms have a non-distortion effect, the first sampling period is set to be related to the motor speed.

In some embodiments, in order to obtain more accurate sampling data, three different first sampling periods are set based on a range of the motor speed. In this case, action at step S21 specifically includes actions at A1 to A3.

At A1, in response to the motor speed of the frequency inverter being smaller than a first rotation speed, t1 is determined as the first predetermined sampling period. The first rotation speed herein may be 3000 rpm (revolution per minute). Assuming that the first rotation speed is 3000 rpm, in response to the motor speed being smaller than 3000 rpm, data is recorded once every four carrier periods, i.e., t1= 4/f1, where f1 represents a carrier frequency of the frequency inverter, i.e., the f1 is first calculated based on the motor speed, and then the t1 is determined based on the f1.

At A2, in response to the motor speed of the frequency inverter being greater than or equal to the first rotation speed and smaller than a second rotation speed, t2 is determined as the first predetermined sampling period. The second rotation speed may be 6000 rpm. Assuming that the first rotation speed value is 3000 rpm, the second rotation speed value is 6000 rpm, and in response to 3000 rpm < the motor speed < 6000 rpm, data is recorded once every two carrier periods, i.e., t2= 2/f2, where f2 represents the carrier frequency of the frequency inverter, i.e., the f2 is first calculated based on the motor speed, and then t2 is determined based on the f2.

At A3, in response to the motor speed of the frequency inverter being greater than or equal to the second rotation speed, t3 is determined as the first predetermined sampling period. Assuming that the second rotation speed is 6000 rpm, in response to 6000 rpm < the rotation speed of the motor, data is recorded once every one carrier period, i.e., t3= 1/f3, where f3 represents the carrier frequency of the frequency inverter, i.e., the f3 is first calculated based on the motor speed, and the t3 is determined based on the f3.

t3 < t2 < t1 < a second predetermined sampling period.

In the above A1 to A3, the corresponding first sampling period is set based on magnitude of the motor speed, and therefore the set first sampling period is closer to the motor speed. Thus, more accurate sampling data is obtained when the performance parameters of the frequency inverter are collected based on the set first sampling period.

At step S22, first sampling data is obtained by sampling a performance parameter of the frequency inverter based on a first predetermined sampling period.

The performance parameter herein refers to data capable of reflecting performance of the frequency inverter, such as a current, a voltage, a motor speed.

The first sampling period herein is a short sampling period. After the first sampling data sampled in the first sampling period is reconstructed, an obtained waveform can reflect specific information of a single waveform.

At step S23, second sampling data is obtained by sampling a performance parameter of the frequency inverter based on a second predetermined sampling period. The first predetermined sampling period is smaller than the second predetermined sampling period.

The second sampling period herein refers to a period longer than the first sampling period. After the second sampling data sampled in the second sampling period is reconstructed, an obtained waveform can reflect an overall trend.

At step S24, in response to a fault in the frequency inverter, fault data prior to and subsequent to the fault in the frequency inverter are stored. The fault data includes the first sampling data and the second sampling data.

In the embodiments of the present disclosure, since the first predetermined sampling period is determined based on the motor speed, it can be ensured that the performance parameter of the frequency inverter is sampled in a more accurate first sampling period. Therefore, accuracy of the obtained first sampling data is improved.

### Embodiments 3:

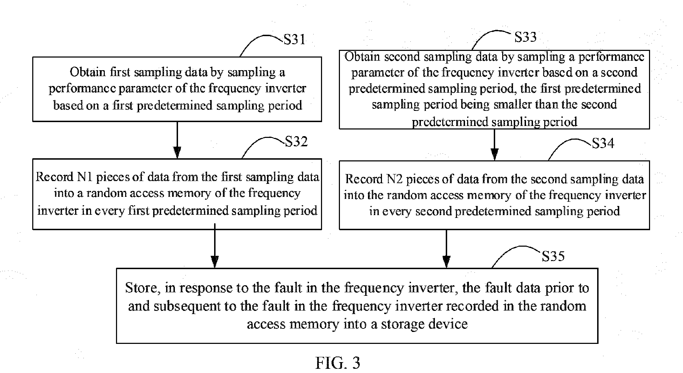

FIG. 3 illustrates a flowchart of a third performance parameter recording method according to this embodiment of the present disclosure. In this embodiment, first sampling data obtained by sampling in a first sampling period and second sampling data sampled by a second sampling period are recorded into a Random Access Memory (RAM) of a frequency inverter, and fault data prior to and subsequent to a fault in the frequency inverter is read from the RAM and stored in a storage device.

At step S31, first sampling data is obtained by sampling a performance parameter of the frequency inverter based on a first predetermined sampling period.

The performance parameter herein refers to data capable of reflecting performance of the frequency inverter, such as a current, a voltage, a motor speed.

The first sampling period herein is a short sampling period. After the first sampling data sampled in the first sampling period is reconstructed, an obtained waveform can reflect specific information of a single waveform.

In some embodiments, referring to the action at step S21, the method further includes, prior to the action at step S31: determining the first predetermined sampling period based on a motor speed of the frequency inverter. The motor speed refers to a motor speed of the frequency inverter.

In this embodiment, the motor speed has an influence on an electrical period of the frequency inverter. Therefore, in order to obtain data of at least two (or more than 5) electrical cycle waveforms and ensure that restored waveforms have a non-distortion effect, the first sampling period is set to be related to the motor speed.

At step S32, N1 pieces of data from the first sampling data is recorded into a random access memory of the frequency inverter every first predetermined sampling period.

At step S33, second sampling data by sampling a performance parameter of the frequency inverter is obtained based on a second predetermined sampling period. The first predetermined sampling period is smaller than the second predetermined sampling period.

The second sampling period herein refers to a period longer than the first sampling period. After the second sampling data sampled in the second sampling period is reconstructed, an obtained waveform can reflect an overall trend.

At step S34, N2 pieces of data from the second sampling data is recorded into the random access memory of the frequency inverter every second predetermined sampling period. N1 and N2 are determined based on a number of random access memories of the frequency inverter and capacity of the single random access memory, and each of N1 and N2 is a natural number greater than 9.

In this embodiment, the RAM of the frequency inverter is configured to record the sampling data and is further configured to record other data of the frequency inverter. Therefore, it is necessary to ensure that the sampling data recorded into the RAM (i.e., the first sampling data obtained by sampling in the first sampling period and the second sampling data obtained by sampling in the second sampling period) cannot occupy all RAM storage space of the frequency inverter. For example, it is necessary to ensure that a ratio of M to space of all the RAMs of the frequency inverter is smaller than 1/2. M is a sum of space occupied by the N1 pieces of data from the first sampling data recorded in the RAM and space occupied by the N2 pieces of data from the second sampling data recorded in the RAM.

In this embodiment, N1 is set to be a natural number greater than 9, and N2 is set to be a natural number greater than 9, to improve accuracy of at least two subsequent restored waveforms. In some embodiments, the first sampling data at least includes two adjacent troughs, three adjacent peaks, and four numerical values corresponding to four adjacent points intersecting with a coordinate axis (such as a horizontal axis). Since the first sampling data includes the above-mentioned numerical value, accuracy of the at least two subsequent restored waveforms can be further improved.

At step S35, in response to a fault in the frequency inverter, fault data prior to and subsequent to the fault in the frequency inverter recorded in the random access memory are stored in storage device. The fault data includes the first sampling data and the second sampling data.

In this embodiment, when it is detected that the fault in the frequency inverter occurs, for example, when a fault code is generated, which indicates that there is a fault in the frequency inverter, in this case, it is determined that each piece of the sampling data prior to the fault in the frequency inverter and the sampling data subsequent to the fault in the frequency inverter (the sampling data includes the first sampling data obtained by sampling in the first sampling period, and second sampling data obtained by sampling in the second sampling period) is stored in the storage device. In this embodiment, in order to avoid a fault caused by a normal power failure, before reading the fault data from the RAM and storing the fault data into the storage device, the fault data is latched and then stored in the storage device after waiting for a predetermined duration. For example, the fault data is stored in the storage device after 10s.

In the embodiments of the present disclosure, even if all the RAMs in the frequency inverter has small storage space, since a quantity of the sampled data recorded into the RAM is determined based on a number of the RAM contained in the frequency inverter and capacity of a single RAM, as long as the quantity of the recorded sampling data is controlled, it is always possible to ensure that, in a case where the storage space of all the RAMs in the frequency inverter is allowed, the performance parameter is recorded (i.e., under specific cache capacity, there is no need to establish a connection with an external device). Meanwhile, since the storage device is only configured to record the fault data prior to the fault and the faults data subsequent to the fault, i.e., there is no need to record the performance parameters of each time period, there is no need to occupy too large space. In addition, since each of the first sampling data and the second sampling data is a natural number greater than 9, it is ensured that performance parameters of the at least two waveforms can be recorded to facilitate subsequent accurate analysis of the waveform.

In some embodiments, the storing the fault data prior to and subsequent to the fault in the frequency inverter recorded in the random access memory into a storage device at step S35 includes actions at steps A1 and A2.

At step A1, the fault data prior to and subsequent to the fault in the frequency inverter recorded in the random access memory are sorted in a chronological order.

At step A2, the sorted fault data from the random access memory is stored into the storage device.

In the above steps A1 and A2, since the first sampling data of the fault data is sampled in the first predetermined sampling period, and the second sampling data of the fault data is sampled in the second predetermined sampling period, the obtained first sampling data and second sampling data have a chronological order. Each piece of fault data is sequenced in combination with the chronological order and then stored in the storage device, and a fault data sequence with the chronological order can be subsequently obtained only by sequentially extracting the fault data from the storage device. Therefore, when the fault data sequence with the chronological order is restored into a waveform, accuracy of the waveform can be ensured.

In some embodiments, when each piece of the sampled data recorded by the RAM is recorded based on the chronological order, each piece of the sampled data is also stored based on the recording sequence of the RAM when stored in the storage device. Therefore, each piece of the sampling data with the chronological order can also be obtained. By storing the sampling data in this way, and the chronological order for sampling corresponding to the sampling data can also be available when the sampling data is subsequently extracted. Alternatively, a sampling time point of each piece of the sampling data is recorded, and the sampling data and the corresponding sampling time point are correspondingly stored in the storage device. By storing the sampling data in this way, the sampling time point corresponding to the sampling data can also be available when the sampling data is subsequently extracted. Therefore, the accuracy of the restored waveform can be ensured.

In some embodiments, in order to ensure that a performance parameter subsequent to the fault in the frequency inverter, the method according to the embodiments of the present disclosure further includes: recording, in response to the fault in the frequency inverter, n1 pieces of data from the first sampling data subsequent to the fault in the frequency inverter and n2 pieces of data from the second sampling data subsequent to the fault in the frequency inverter into the random access memory, each of n1 and n2 being a natural number greater than 1.

Correspondingly, the above step A1 includes: sorting, in the chronological order, (N1-n1) pieces of data from the first sampling data prior to the fault in the frequency inverter, (N2-n2) pieces of data from the second sampling data prior to the fault in the frequency inverter, the n1 pieces of data from the first sampling data subsequent to the fault in the frequency inverter, and the n2 pieces of data from the second sampling data subsequent to the fault in the frequency inverter recorded in the random access memory.

In this embodiment, after the fault occurs in the frequency inverter, sampling is continued, and first sampling data (n1 pieces) and second sampling data (n2 pieces) that are obtained by sampling after the fault occurs are recorded, individually. That is, it is ensured that a total number of sampling points of the first sampling data recorded in the RAM is N1, and the N1 sampling points include sampling points before the fault occurs and sampling points after the fault occurs. A recording condition of the second sampling data is similar to that of the first sampling data, and details thereof are not repeated herein.

In some embodiments, since the performance parameter before the fault occurs is more helpful for an analyst, it is set to have more sampling data recorded in the RAM and prior to the fault than the sampling data recorded in the RAM and subsequent to the fault. For example, (N1-n1)/ N1= 4: 1; (N2-n2)/ N2= 4: 1. It should be noted that the "4: 1" herein is a range, and in a practical situation, it is not necessary to be strictly limited to an equal ratio, as long an approximation to this ratio is sufficient. For example, assuming that N1= 128, n1= 26, N1-n1= 128-26= 102, and in this case, 102/26= 3.9, i.e., approximately equal to 4, which also belongs to the above situation.

In some embodiments, n1= n2, and/or N 1= N 2.

In some embodiments, the frequency inverter may interact with other communication devices. In this case, the performance parameter recording method according to the embodiments of the present disclosure further includes actions at steps B1 to B3.

At step B1, whether an instruction transmitted by a communication device is an operation waveform query instruction is identified. The communication device herein includes an upper computer, a mobile terminal (such as a mobile phone, a tablet computer), a cloud server, etc.

At step B2, in response to identifying that the instruction transmitted by the communication device is the operation waveform query instruction, N1 pieces of data in newly sampled first sampling data is acquired, and the N1 pieces of data in the newly sampled first sampling data is transmitted to the communication device.

At step B3, in response to identifying that the instruction transmitted by the communication device is a fault waveform query instruction, the stored fault data is transmitted to the communication device.

The operation waveform query instruction is configured to query a corresponding performance parameter during normal operation of the frequency inverter, for example, to query a performance parameter of a motor of the frequency inverter. In some embodiments, in order to ensure that the transmitted performance parameter can best reflect a current operation state of the frequency inverter, the first sampling data recorded in the RAM is updated, and the updated first sampling data in the RAM is transmitted to the communication device.

The fault waveform query instruction is configured to query corresponding fault data during the fault in the frequency inverter. In this embodiment, the communication device may specify to query fault data corresponding to a fault of a specific type, or specify to query fault data corresponding to a fault occurring in a specific time period, or query all fault data recorded by the frequency inverter.

In some embodiments, the above performance parameter is a performance parameter of the motor. For example, when the frequency inverter has only one motor, the performance parameter of the frequency inverter is the performance parameter of the motor; and when the frequency inverter has two or more motors, the performance parameter of the frequency inverter may include the performance parameter of each of the two or more motors. That is, the performance parameter of the frequency inverter in the embodiments of the present disclosure includes the performance parameter of the one or more motors. Since the performance parameters of the plurality of motors can be sampled, the performance parameters of the plurality of motors do not need to be collected one by one. Therefore, subsequent rapid and effective analysis of a cause of the fault in the plurality of motors is facilitated.

In some embodiments, when the performance parameter that needs to be collected is the performance parameter of the motor, the performance parameter includes at least one of a current, a voltage, a motor speed, or a motor back electromotive force voltage.

The above "current" may be a phase current of the motor, for example, a U-phase current, a V-phase current, and a W-phase current.

The above "voltage" may be a phase voltage of the motor, or may be a bus voltage of the motor.

In this embodiment, when the performance parameters are collected more (for example, the U-phase current, the V-phase current, the W-phase current, the bus voltage, and the motor speed are collected at the same time), the more the accuracy of the analysis result obtained during subsequent fault analysis can be improved. Further, the frequency inverter itself needs to read the performance parameter such as the current, the voltage, and the motor speed, and therefore these performance parameters are directly collected by the frequency inverter. Thus, consumption of resources can be reduced as much as possible.

In some embodiments, in order to facilitate distinguishing which sampling data is the first sampling data and which sampling data is the second sampling data, the method according to the embodiments of the present disclosure further includes: recording the N1 pieces of data from the first sampling data and the N2 pieces of data from the second sampling data into different structure arrays of the random access memory, respectively.

In this embodiment, the different structure arrays are predetermined to store the first sampling data and the second sampling data. For example, a structure array DataFast is predetermined to store the first sampling data, and a structure array DataSlow is predetermined to store the second sampling data. Assuming that a length of each channel in the DataFast is 128 (16 bit), N1= 128, and the first sampling data consists of the U-phase current (an instantaneous value of a U-phase current), the bus voltage, and the motor speed, space occupied by recording the first sampling data in the RAM is 128*2*3= 768 byte.

In some embodiments, in the above steps B2 and B3, the frequency inverter interacts with the communication device in any communication manner of serial port communication, inter-integrated circuit (I2C), Controller Area Network (CAN), and Bluetooth. For example, in the step B2, the frequency inverter transmits N1 pieces of first sampling data to the communication device through the serial port communication.

In some embodiments, the storage device includes at least one of an Electrically Erasable Programmable Read-only Memory (EEPROM), a Flash Memory (FLASH), a USB Mass Storage Device (USB flash disk), or a Secure Digital Memory Card (SD card).

In order to more clearly describe the performance parameter recording method according to the embodiments of the present disclosure, the following description will be made with the first predetermined sampling period determined by the motor speed, and the performance parameters including the bus voltage, the U-phase current and the motor rotating speed.

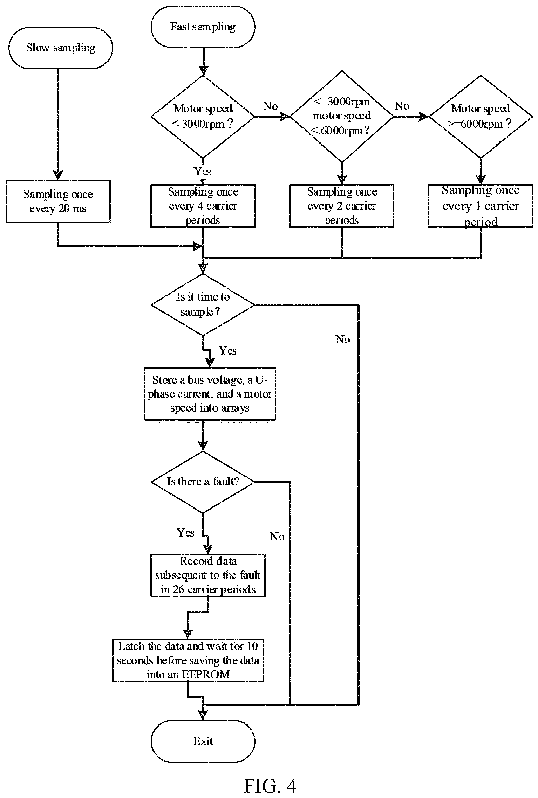

FIG. 4 illustrates a flowchart of another performance parameter recording method according to Embodiment 3 of the present disclosure.

In FIG. 4, the performance parameter of the frequency inverter is sampled in two manners of fast sampling and slow sampling. The fast sampling is equivalent to sampling the performance parameter of the frequency inverter in the first sampling period, and the slow sampling is equivalent to sampling the performance parameter of the frequency inverter in the second sampling period. In the fast sampling, the motor speed of the frequency inverter is first determined. In response to the motor speed being less than 3000 rpm, the performance parameter is sampled once every four carrier periods; in response to the motor speed being greater than or equal to 3000 rpm and smaller than 6000 rpm, the performance parameter is sampled once every two carrier periods; and in response to the rotation speed of the motor being greater than or equal to 6000 rpm, the performance parameter is sampled once every one carrier period. During the fast sampling process, the slow sampling is also required, i.e., the performance parameter is sampled once every fixed 20 ms. After a sampling time is up, N1 pieces (e.g., 128) of the first sampling data (a bus voltage, a U-phase current, a motor speed) obtained through the fast sampling is stored in arrays of RAM, and N2 pieces of the second sampled data (a bus voltage, a U-phase current, a motor speed) obtained through the slow sampling is stored in structure arrays of RAM. When the fault in the frequency inverter occurs, data subsequent to the fault in 26 carrier periods is recorded, and the 128 pieces of data of the first sampling data recorded by the RAM and the 128 pieces of data of the second sampling data recorded by the RAM are stored in an EEPROM of the frequency inverter.

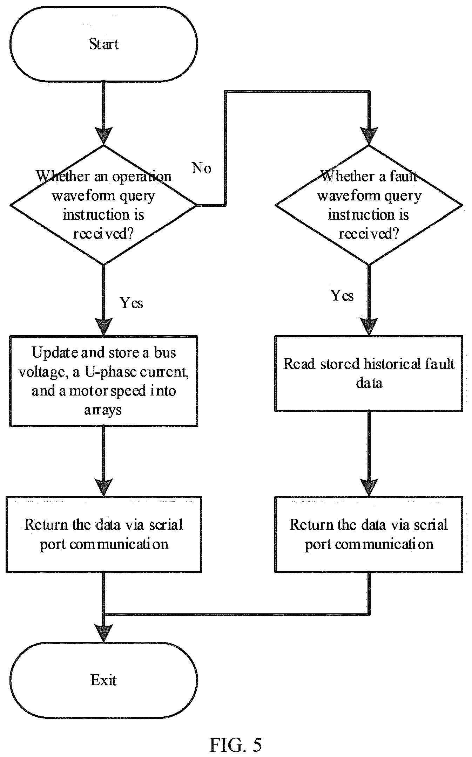

After the performance parameter is recorded by the frequency inverter, the frequency inverter may interact with the communication device. FIG. 5 illustrates a flowchart of a frequency inverter after receiving an instruction of a communication device.

In FIG. 5, after the instruction is received by the frequency inverter, it is identified whether the received instruction is an operation waveform query instruction. In response to identifying that the received instruction is the operation waveform query instruction, the bus voltage, the U-phase current, and the motor speed are updated and stored in the structure arrays of the RAM, and then the bus voltage, the U-phase current, and the motor speed in the structure arrays are transmitted to the communication device through the serial port communication. The updated bus voltage, U-phase current, and motor speed herein are the sampling data obtained through the fast sampling. In response to identifying that the received instruction is not the operation waveform query instruction (i.e., a fault waveform query instruction), stored historical fault data (sampled data obtained by fast sampling and slow sampling) is read and transmitted to the communication device.

When the performance parameter of the frequency inverter is received by the communication device during the operation of the frequency inverter, or the performance parameter of the frequency inverter prior to the fault in the frequency inverter and the performance parameter of the frequency inverter subsequent to the fault in the frequency inverter are received by the communication device, the corresponding waveform can be reconstructed based on the performance parameters to analyze performance of the frequency inverter.

A difference between the waveform obtained by reconstructing the performance parameter stored in the embodiments of the present disclosure and a waveform obtained by the oscilloscope is described below with reference to specific comparison diagrams.

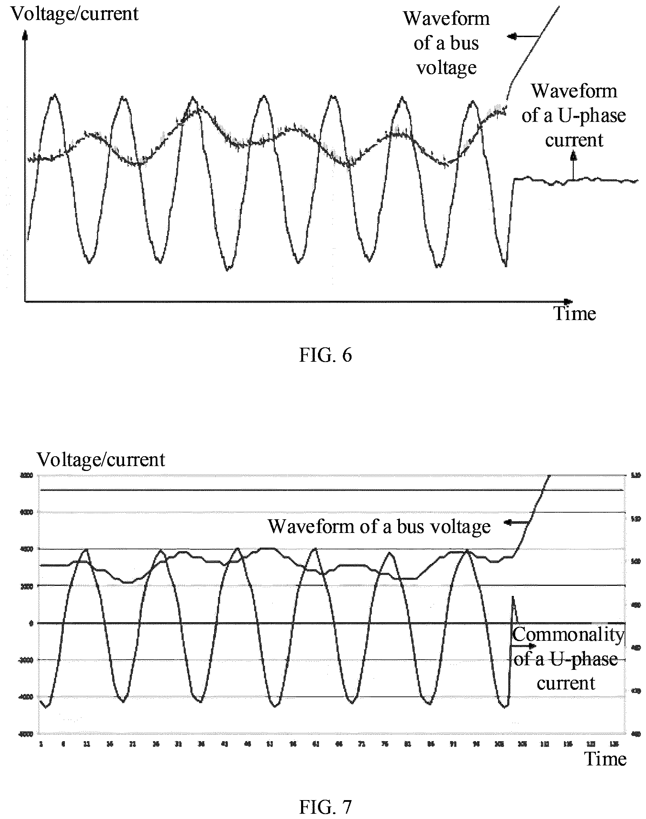

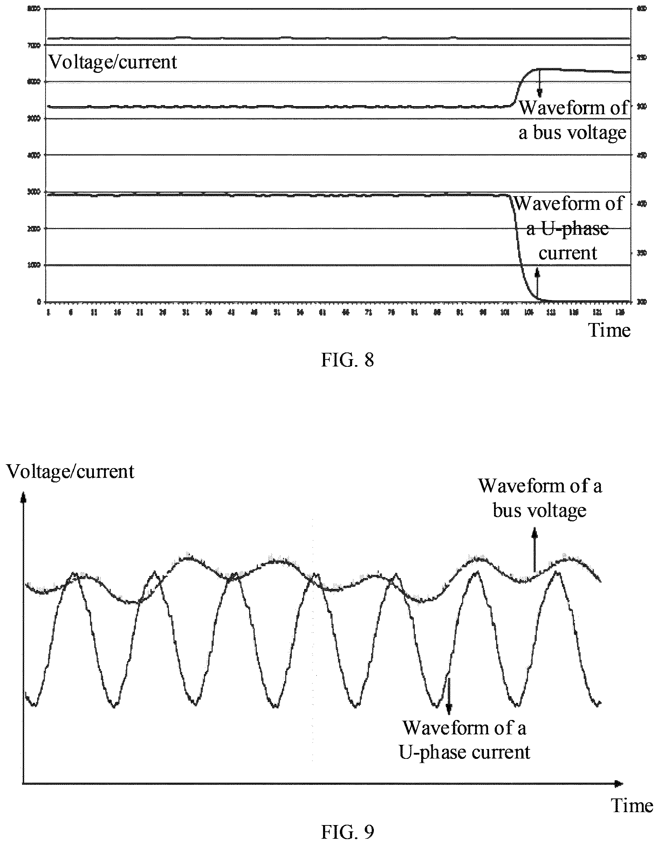

Assuming that a compressor of the frequency inverter has an overcurrent fault at 7200 rpm, when collecting by the oscilloscope, a schematic diagram of a waveform as illustrated in FIG. 6 is obtained, referring to FIG. 6 for details; when the first sampling data collected in the embodiments of the present disclosure is reconstructed, a waveform diagram as illustrated in FIG. 7 is obtained; and when the collected second sampling data is reconstructed, a waveform diagram as illustrated in FIG. 8 is obtained.

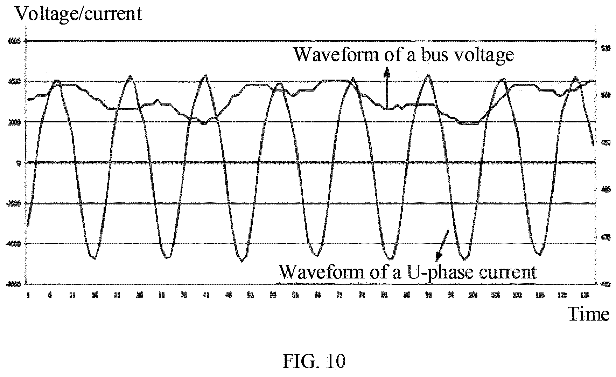

Assuming that the performance parameter received by the communication device is a corresponding performance parameter during the operation of the frequency inverter at 7200 rpm, when collecting by the oscilloscope, a schematic diagram of a waveform as illustrated in FIG. 9 is obtained; and when the first sampling data collected in the embodiments of the present disclosure is reconstructed, a schematic diagram of a waveform diagram as illustrated in FIG. 10 is obtained.

As illustrated in FIG. 6 to FIG. 10, the obtained waveform subject to reconstruction of the sampling data collected in the embodiments of the present disclosure is basically consistent with the obtained waveform collected by the oscilloscope, and an effective current and a changing condition of the bus voltage around 2 seconds before the fault can be reconstructed based on the second sampling data collected in the embodiments of the present disclosure. Therefore, the fault can be analyzed more comprehensively. In addition, when the performance parameter recording method according to the embodiments of the present disclosure is used to record the performance parameter, for example, when both N1 and N2 are set to 128, it only requires 1536 bytes in RAM, i.e., 1.5K, which means that the fault can be accurately analyzed at a relatively low cost.

It should be understood that in the embodiments of the present disclosure, numerical values of sequence numbers of the above steps do not mean an execution order and should not constitute any limitation to an implementation process of the embodiments of the present disclosure as the execution order of individual processes should be determined by their functions and internal logics.

### Embodiment 4:

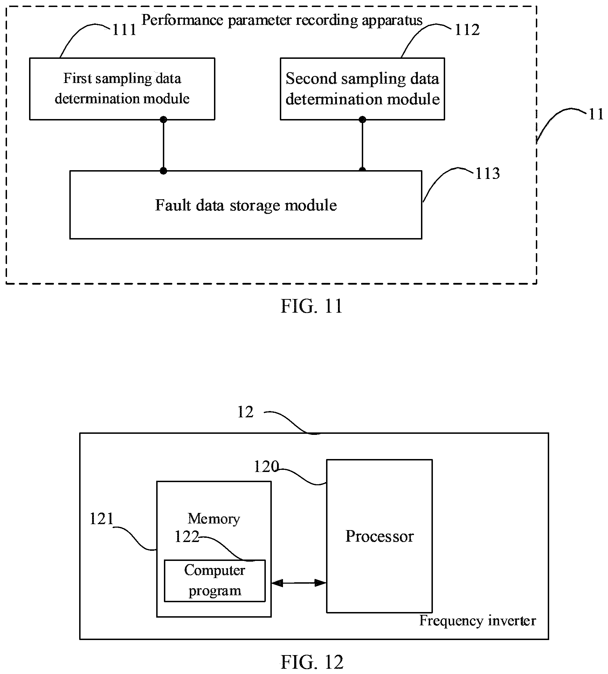

Corresponding to the methods described in Embodiments 1, 2, and 3 above, FIG. 11 illustrates a block diagram of a performance parameter recording apparatus according to this embodiment of the present disclosure. The performance parameter recording apparatus is for a frequency inverter, and for ease of description, only a part related to the embodiments of the present disclosure is illustrated.

Referring to FIG. 11, a performance parameter recording apparatus 11 includes: a first sampling data determination module 111, a second sampling data determination module 112, and a fault data storage module 113.

The first sampling data determination module 111 is configured to obtain first sampling data by sampling a performance parameter of the frequency inverter based on a first predetermined sampling period.

In this embodiment, the first sampling data is restored, and a situation of each waveform can be observed.

The second sampling data determination module 112 is configured to obtain second sampling data by sampling a performance parameter of the frequency inverter based on a second predetermined sampling period. The first predetermined sampling period is smaller than the second predetermined sampling period.

In this embodiment, the second sampling data is restored, and a trend of the performance parameter within a period of time can be observed.

The fault data storage module 113 is configured to store, in response to a fault in the frequency inverter, fault data prior to and subsequent to the fault in the frequency inverter, the fault data comprising the first sampling data and the second sampling data.

In this embodiment of the present disclosure, since the fault data consists of the corresponding sampling data prior to the fault in the frequency inverter and the corresponding sampling data subsequent to the fault in frequency inverter, subsequently, the fault can be accurately analyzed based on the fault data. Meanwhile, since the fault data is recorded by the frequency inverter itself, and the frequency inverter does not need to be connected to the oscilloscope, the operation convenience can be improved. In addition, since the fault data is obtained by sampling the performance parameters in one first sampling period and one second sampling period, the sampling data in different sampling periods can be obtained. As a result, the subsequent analysis of the performance parameters from different angles is facilitated, i.e., the accuracy of the subsequently obtained analysis result is improved.

In some embodiments, the performance parameter recording apparatus 11 further includes a first sampling period determination module configured to determine the first predetermined sampling period based on a motor speed of the frequency inverter.

The motor speed refers to a motor speed of the frequency inverter. In this way, it can be ensured that the collected performance parameters are easier to observe when reconstructed into the waveform.

In some embodiments, the above first sampling period determination module specifically includes: a first sampling period determination unit corresponding to a first rotation speed, a first sampling period determination unit corresponding to a second rotation speed, and a first sampling period determination unit corresponding to a third rotation speed.

The first sampling period determination unit corresponding to the first rotation speed is configured to determine, in response to the motor speed of the frequency inverter being smaller than a first rotation speed, t1 as the first predetermined sampling period. The first rotation speed herein may be 3000 rpm. Assuming that the first rotation speed is 3000 rpm, in response to the motor speed being smaller than 3000 rpm, data is recorded once every four carrier periods, i.e., t1= 4/f1.

The first sampling period determination unit corresponding to the second rotation speed is configured to determine, in response to the motor speed of the frequency inverter being greater than or equal to the first rotation speed and smaller than a second rotation speed, t2 as the first predetermined sampling period. The second rotation speed herein may be 6000 rpm. Assuming that the first rotation speed is 3000 rpm, the second rotation speed is 6000 rpm, and in response to 3000 rpm< the motor speed< 6000 rpm, data is recorded once every two carrier periods, i.e., t2= 2/f 2.

The first sampling period determination unit corresponding to the third rotation speed is configured to in response to the motor speed of the frequency inverter being greater than or equal to the second rotation speed, t3 as the first predetermined sampling period. In repose to 6000 rpm< the motor speed, data is recorded once every one carrier period, i.e., t3= 1/f3.

t3 < t2 < t1 < the second predetermined sampling period.

Since the corresponding first sampling period is set based on magnitude of the motor speed, and therefore the set first sampling period is closer to the motor speed. Thus, more accurate sampling data is obtained when the performance parameters of the frequency inverter are collected based on the set first sampling period.

In some embodiments, the performance parameter recording apparatus 11 further includes: a first sampling data recording module and a second sampling data recording module.

The first sampling data recording module is configured to record N1 pieces of data from the first sampling data into a random access memory of the frequency inverter every first predetermined sampling period.

The second sampling data recording module is configured to record N2 pieces of data from the second sampling data into the random access memory of the frequency inverter every second predetermined sampling period. N1 and N2 are determined based on a number of random access memories of the frequency inverter and capacity of the single random access memory, and each of N1 and N2 is a natural number greater than 9.

Correspondingly, the above fault data storage module 113 is specifically configured to store, in response to a fault in the frequency inverter, fault data prior to and subsequent to the fault in the frequency inverter into storage device. The fault data includes the first sampling data and the second sampling data. In this embodiments, when it is detected the fault in the frequency inverter occurs, for example, when a fault code is generated, which indicates that there is a fault in the frequency inverter, in this case, it is determined that each piece of the sampling data prior to the fault in the frequency inverter and the sampling data subsequent to the fault in the frequency inverter is stored in the storage device. In some embodiments, each piece of the sampling data is stored in the storage device after waiting for a predetermined duration. For example, each piece of the sampling data is stored in the storage device after waiting for 10s.

In this embodiment, due to the fact that the RAM of the frequency inverter is configured to record the sampling data and is further configured to record other data of the frequency inverter, it is necessary to ensure that the first sampling data recorded into the RAM and the second sampling data recorded into the RAM cannot occupy all RAM storage spaces of the frequency inverter. For example, it is necessary to ensure that a ratio of N1 pieces of data of the first sampling data recorded in the RAM and the RAM space occupied by N2 pieces of data of the second sampling data recorded in the RAM to space of all the RAMs of the frequency inverter is smaller than 1/2.

In the above embodiment, each of N1 (a quantity of first sampling data) and N2 (a quantity of first sampling data) is set to be a natural number greater than 9, to improve the accuracy of the at least two subsequent restored waveforms. In some embodiments, the above first sampling data at least includes two adjacent troughs, three adjacent peaks, and four numerical values corresponding to four adjacent points intersecting with a coordinate axis (such as the horizontal axis). Since the first sampling data includes the above numerical value, the accuracy of the at least two subsequent restored waveforms can be further improved.

In some embodiments, the fault data storage module 113, when storing the fault data prior to and subsequent to the fault in the frequency inverter recorded in the random access memory into the storage device, is specifically configured to: sort, in a chronological order, the fault data prior to and subsequent to the fault in the frequency inverter recorded in the random access memory; and store the sorted fault data from the random access memory into the storage device.

In this embodiment, since the first sampling data of the fault data is sampled in the first predetermined sampling period, and the second sampling data of the fault data is sampled in the second predetermined sampling period, the obtained first sampling data and second sampling data have a chronological order. Each piece of fault data is sequenced in combination with the chronological order and then stored in the storage device, and a fault data sequence with the chronological order can be subsequently obtained only by sequentially extracting the fault data from the storage device. Therefore, when the fault data sequence with the chronological order is restored into a waveform, accuracy of the waveform can be ensured.

In some embodiments, when each piece of the sampled data recorded by the RAM is recorded based on the chronological order, each piece of the sampled data is also stored based on the recording sequence of the RAM when stored in the storage device. Therefore, each piece of the sampling data with the chronological order can also be obtained.

In some embodiments, the performance parameter recording apparatus 11 further includes a post-fault sampling data recording module configured to record, in response to the fault in the frequency inverter, each piece of n1 pieces of data from the first sampling data subsequent to the fault in the frequency inverter and n2 pieces of data from the second sampling data subsequent to the fault in the frequency inverter into the random access memory. Each of n1 and n2 is a natural number greater than 1.

Correspondingly, the above fault data storage module 113, when sorting, in the chronological order, the fault data prior to and subsequent to the fault in the frequency inverter recorded in the random access memory, is specifically configured to: sort, in the chronological order, (N1-n1) pieces of data from the first sampling data prior to the fault in the frequency inverter, (N2-n2) pieces of data from the second sampling data prior to the fault in the frequency inverter, the n1 pieces of data from the first sampling data subsequent to the fault in the frequency inverter, and the n2 pieces of data from the second sampling data subsequent to the fault in the frequency inverter recorded in the random access memory.

In this embodiment, through the above setting, it is ensured that a total number of sampling points of the first sampling data recorded in the RAM is N1, and the N1 sampling points include sampling points before the fault occurs and sampling points after the fault occurs.

In some embodiments, (N1-n1)/ N1= 4: 1; and (N2-n2)/ N2= 4: 1. It should be noted that the "4: 1" herein is a range, and in a practical situation, it is not necessary to be strictly limited to an equal ratio, as long as an approximation to this ratio is sufficient.

In some embodiments, n1= n2, and/or N1= N2.

In some embodiments, the performance parameter recording apparatus 11 further includes: an instruction identification module, an operation data transmission module, and a fault data transmission module.

The instruction identification module is configured to identify whether an instruction transmitted by a communication device is an operation waveform query instruction. The communication device herein includes an upper computer, a mobile terminal (such as a mobile phone, a tablet computer), a cloud server, etc.

The operation data transmission module is configured to: acquire, in response to identifying that the instruction transmitted by the communication device is the operation waveform query instruction, N1 pieces of data in newly sampled first sampling data, and transmit the N1 pieces of data in the newly sampled first sampling data to the communication device.

The fault data transmission module is configured to transmit, in response to identifying that the instruction transmitted by the communication device is a fault waveform query instruction, the stored fault data to the communication device.

The operation waveform query instruction is configured to query a corresponding performance parameter during normal operation of the frequency inverter, for example, to query a performance parameter of a motor of the frequency inverter. In some embodiments, in order to ensure that the transmitted performance parameter can best reflect a current operation state of the frequency inverter, the first sampling data recorded in the RAM is updated, and the updated first sampling data in the RAM is transmitted to the communication device.

The fault waveform query instruction is configured to query corresponding fault data during the fault in the frequency inverter. In this embodiment, the communication device may specify to query fault data corresponding to a fault of a specific type, or specify to query fault data corresponding to a fault occurring in a specific time period, or query all fault data recorded by the frequency inverter.

In some embodiments, when the frequency inverter has only one motor, the performance parameter of the frequency inverter is the performance parameter of the motor; and when the frequency inverter has two or more motors, the performance parameter of the frequency inverter may include the performance parameter of each of the two or more motors. That is, the above performance parameter of the frequency inverter includes the performance parameter of the one or more motors.

In some embodiments, the performance parameter includes at least one of a current, a voltage, a motor speed, or a motor back electromotive force voltage.

The above "current" may be a phase current of the motor, for example, a U-phase current, a V-phase current, and a W-phase current.

The above "voltage" may be a phase voltage of the motor, or may be a bus voltage of the motor.

In this embodiment, when the performance parameters are collected more (for example, the U-phase current, the V-phase current, the W-phase current, the bus voltage, and the motor speed are collected at the same time), the more the accuracy of the analysis result obtained during subsequent fault analysis can be improved.

In some embodiments, the performance parameter recording apparatus 11 further includes: an RAM storage module configured to record the N1 pieces of data from the first sampling data and the N2 pieces of data from the second sampling data into different structure arrays of the random access memory.

In this embodiment, different structure arrays are predetermined to store the first sampling data and the second sampling data.

In some embodiments, the frequency inverter interacts with the communication device in any communication manner of serial port communication, I2C, CAN, and Bluetooth.

In some embodiments, the storage device includes at least one of an EEPROM, a FLASH, a USB flash disk, an SD card.

It should be noted that contents such as information interaction and execution processes between the above apparatuses/modules are based on the same concept as the method embodiments of the present disclosure, and therefore specific functions and technical effects brought by the specific functions may be found in the parts of the method embodiments, and details thereof are not repeated herein.

### Embodiment 5:

FIG. 12 is a schematic structural diagram of a frequency inverter according to an embodiment of the present disclosure. As illustrated in FIG. 12, a frequency inverter 12 of this embodiment includes: at least one processor 120 (only one processor is illustrated in FIG. 12), a memory 121, and a computer program 122 stored on the memory 121 and executable on the at least one processor 120. The processor 120 is configured to execute the computer program 122 to implement the steps in any of the above method embodiments.

The frequency inverter 12 may be a desktop computer, a notebook computer, a handheld computer, a cloud server, and other computing devices. The frequency inverter may include, but is not limited to, the processor 120 and the memory 121. It may be understood by those skilled in the art that FIG. 12 is merely an example of the frequency inverter 12, and does not constitute a limitation on the frequency inverter 12, and may include more or fewer components than those illustrated in the figures, or combine certain components, or have a different arrangement of components. For example, the frequency inverter may further include an input/output device, a network access device, etc.

The processor 120 may be a Central Processing Unit (CPU). And the processor 120 may further be other general-purpose processors, a Digital Signal Processor (DSP), an Application Specific Integrated Circuit (ASIC), a Field-Programmable Gate Array (FPGA) or other programmable logic devices, a discrete gate or a transistor logic device, and a discrete hardware component. The general-purpose processor may be a microprocessor, or the processor may further be any conventional processor, etc.

The memory 121 in some embodiments may be an internal storage unit of the frequency inverter, such as a hard disk or a memory of the frequency inverter. The memory 121 in other embodiments may also be an external storage device of the frequency inverter, for example, a plug-in hard disk, a Smart Media Card (SMC), a Secure Digital (SD) card, a flash card (Flash Card), etc., which are equipped on the frequency inverter. Further, the memory 121 may also include both the internal storage unit of the frequency inverter and the external storage device of the frequency inverter. The memory 121 is configured to store an operating system, an application, a Boot Loader, data, other programs, etc., such as a program code of a computer program. The memory 121 may also be configured to temporarily store data that has been or is about to be outputted.

Those skilled in the art can clearly understand that, for convenience and brevity of description, only the division of the above functional modules is used as an example for illustration. In practical applications, the above functions can be assigned to different functional modules as needed. That is, the internal structure of the device is divided into different functional modules to achieve some or all of the functions described above. Each functional module in the embodiments may be integrated in a processing module, or these modules may be separate physical existence, or two or more modules are integrated in a processing module. The above integrated module may be realized in a form of hardware or in a form of software function modules. In addition, the specific names of the functional modules are merely for facilitating mutual differentiation, and are not used to limit the protection scope of the present application. For the specific operation process of the modules in the above system, reference may be made to the corresponding process in the above method embodiments, and details thereof are not repeated herein.

The embodiments of the present disclosure include an air conditioner. The air conditioner includes the above frequency inverter.

The embodiments of the present disclosure further provide a network device. The network device includes: at least one processor, a memory, and a computer program stored on the memory and executable on the at least one processor. The processor is configured to execute the computer program to implement the steps in any of the above method embodiments.

The embodiments of the present disclosure further provide a storage medium. The storage medium has a computer program stored thereon. The computer program, when executed by a processor, implements the steps in any of the above method embodiments.

The embodiments of the present disclosure provide a computer program product. The computer program product, when running on a mobile terminal, causes the mobile terminal to implement the steps in the above method embodiments.

When the integrated module is implemented in the form of the software functional unit and is sold or used as a standalone product, it can be stored in a computer-readable storage medium. Based on this understanding, all or some of the processes in the above method embodiments implemented in the present disclosure, may be completed by instructing related hardware by means of a computer program. The computer program, when executed by a processor, may implement the steps according to any one of the above embodiments. The computer program includes computer program codes that may be in a source code form, an object code form, an executable file, an intermediate form, etc. The computer-readable storage medium at least includes any entity or device capable of carrying computer program codes into the frequency inverter, a recording medium, a computer memory, a Read-only Memory (ROM), a Random Access Memory (RAM), an electrical carrier signal, a telecommunication signal, and a software distribution medium, for example, a USB flash disk, a mobile hard disk, a magnetic disk, or an optical disk. In some jurisdictions, according to legislation and patent practice, computer-readable medium may not be electric carrier signals and telecommunication signals.

In above embodiments, descriptions of respective embodiments are emphasized differently, and parts that are not detailed in some embodiments can refer to relevant descriptions of other embodiments.

Those skilled in the art could be aware that, exemplary units and algorithm steps described in combination with embodiments disclosed herein may be implemented by electronic hardware, or by a combination of computer software and electronic hardware. Whether these functions are executed by hardware or software is dependent on particular use and design constraints of the technical solutions. Professionals may adopt different methods for different particular uses to implement described functions, which should not be regarded as going beyond the scope of the present disclosure.

In several embodiments provided by the present disclosure, it should be understood that, the disclosed system, device and method may be implemented in other ways. For example, the device embodiments described above are merely illustrative. For example, the units are merely divided according to logic functions, and can be divided in other ways in actual implementation. For example, a plurality of units or components may be combined or may be integrated into another system, or some features may be ignored or not executed. In addition, the mutual coupling or direct coupling or communication connection illustrated or discussed may be via some interfaces, or direct coupling or communication connection of devices or units may be in an electrical, mechanical, or other form.

The units described as separate parts may or may not be physically separated. Parts displayed as units may or may not be physical units, i.e., the parts may be located in one place, or may be distributed on a plurality of network units. Some or all of the units can be selected according to actual needs to achieve purposes of solutions of the embodiments.

The above embodiments are merely used to illustrate the technical solutions of the present disclosure, rather than limiting the technical solutions of the present disclosure. Although the present disclosure has been described in detail with reference to the above embodiments, it should be understood that those skilled in the art can still make modifications to the technical solutions recorded in the above embodiments, or equivalent substitutions of some of the technical features therein. These modifications or substitutions however, do not depart the essence of the corresponding technical solution from the idea and scope of the technical solution of each embodiment of the present disclosure, and shall fall within the protection scope of the present disclosure.

## Claims

1. A performance parameter recording method for a frequency inverter comprising:
obtaining first sampling data by sampling a performance parameter of the frequency inverter based on a first predetermined sampling period;
obtaining second sampling data by sampling a performance parameter of the frequency inverter based on a second predetermined sampling period, the first predetermined sampling period being smaller than the second predetermined sampling period; and
storing, in response to a fault in the frequency inverter, fault data prior to and subsequent to the fault in the frequency inverter, the fault data comprising the first sampling data and the second sampling data.

2. The performance parameter recording method according to claim 1, prior to said sampling the performance parameter of the frequency inverter based on the first predetermined sampling period, further comprising:
determining the first predetermined sampling period based on a motor speed of the frequency inverter.

3. The performance parameter recording method according to claim 2, wherein said determining the first predetermined sampling period based on the motor speed of the frequency inverter comprises:
determining, in response to the motor speed of the frequency inverter being smaller than a first rotation speed, t1 as the first predetermined sampling period;
determining, in response to the motor speed of the frequency inverter being greater than or equal to the first rotation speed and smaller than a second rotation speed, t2 as the first predetermined sampling period; and
determining, in response to the motor speed of the frequency inverter being greater than or equal to the second rotation speed, t3 as the first predetermined sampling period;
wherein t3 < t2 < t1 < the second predetermined sampling period.

4. The performance parameter recording method according to claim 1, further comprising:
subsequent to said obtaining the first sampling data, recording N1 pieces of data from the first sampling data into a random access memory of the frequency inverter every first predetermined sampling period;
subsequent to said obtaining the second sampling data, recording N2 pieces of data from the second sampling data into the random access memory of the frequency inverter every second predetermined sampling period,
wherein, N1 and N2 are determined based on a number of random access memories of the frequency inverter and a capacity of a single random access memory, and each of N1 and N2 is a natural number greater than 9, and
wherein said storing, in response to the fault in the frequency inverter, the fault data prior to and subsequent to the fault in the frequency inverter comprises:
storing, in response to the fault in the frequency inverter, the fault data prior to and subsequent to the fault in the frequency inverter recorded in the random access memory into a storage device.

5. The performance parameter recording method according to claim 4, wherein said storing the fault data prior to and subsequent to the fault in the frequency inverter recorded in the random access memory into the storage device comprises:
sorting, in chronological order, the fault data prior to and subsequent to the fault in the frequency inverter recorded in the random access memory; and
storing the sorted fault data from the random access memory into the storage device.

6. The performance parameter recording method according to claim 5, further comprising:
recording, in response to the fault in the frequency inverter, n1 pieces of data from the first sampling data subsequent to the fault in the frequency inverter and n2 pieces of data from the second sampling data subsequent to the fault in the frequency inverter into the random access memory, each of n1 and n2 being a natural number greater than 1; and
said sorting, in chronological order, the fault data prior to and subsequent to the fault in the frequency inverter recorded in the random access memory comprises:
sorting, in chronological order, (N1-n1) pieces of data from the first sampling data prior to the fault in the frequency inverter, (N2-n2) pieces of data from the second sampling data prior to the fault in the frequency inverter, the n1 pieces of data from the first sampling data subsequent to the fault in the frequency inverter, and the n2 pieces of data from the second sampling data subsequent to the fault in the frequency inverter recorded in the random access memory.

7. The performance parameter recording method according to claim 6, wherein (N1-n1) / n1 = 4: 1, and (N2-n2) / n 2 = 4: 1.

8. The performance parameter recording method according to claim 1, further comprising:
identifying whether an instruction transmitted by a communication device is an operation waveform query instruction;
acquiring, in response to identifying that the instruction transmitted by the communication device is the operation waveform query instruction, N1 pieces of data in newly sampled first sampling data, and transmitting the N1 pieces of data in the newly sampled first sampling data to the communication device; and
transmitting, in response to identifying that the instruction transmitted by the communication device is a fault waveform query instruction, the stored fault data to the communication device.

9. The performance parameter recording method according to any one of claims 1 to 8, wherein the performance parameter of the frequency inverter comprises one or more performance parameters of one or more motors of the frequency inverter.

10. The performance parameter recording method according to claim 9, wherein the performance parameter comprises at least three of a current, a voltage, a motor speed, or a motor back electromotive force voltage.

11. The performance parameter recording method according to any one of claims 4 to 7, further comprising:
recording the N1 pieces of data from the first sampling data and the N2 pieces of data from the second sampling data into different structure arrays of the random access memory respectively.

12. A performance parameter recording apparatus for a frequency inverter and comprising:
a first sampling data determination module configured to obtain first sampling data by sampling a performance parameter of the frequency inverter based on a first predetermined sampling period;
a second sampling data determination module configured to obtain second sampling data by sampling a performance parameter of the frequency inverter based on a second predetermined sampling period, the first predetermined sampling period being smaller than the second predetermined sampling period; and
a fault data storage module configured to store, in response to a fault in the frequency inverter, fault data prior to and subsequent to the fault in the frequency inverter, the fault data comprising the first sampling data and the second sampling data.

13. A frequency inverter, comprising:
a memory;
a processor; and
a computer program stored on the memory and executable on the processor,
wherein the processor is configured to execute the computer program to implement a method according to any one of claims 1 to 11.

14. An air conditioner, comprising a frequency inverter according to claim 13.

15. A storage medium, having a computer program stored thereon,
wherein the computer program, when executed by a processor, implements a method according to any one of claims 1 to 11.
